Europäisches Patentamt

European Patent Office

Office européen des brevets

(19)

(11) Publication number: **0 071 203**
**A2**

(12) # EUROPEAN PATENT APPLICATION

(21) Application number: 82106651.1

(22) Date of filing: 23.07.82

(51) Int. Cl.³: **H 01 L 21/32**
**H 01 L 21/314, H 01 L 21/76**

(30) Priority: 30.07.81 US 288599

(43) Date of publication of application:
09.02.83 Bulletin 83/6

(84) Designated Contracting States:
DE FR GB IT

(71) Applicant: International Business Machines
Corporation

Armonk, N.Y. 10504(US)

(72) Inventor: Kemlage, Bernard Michael
Route No. 1, Box 344A
Kingston New York 12401(US)

(74) Representative: Kreidler, Eva-Maria, Dr. rer. nat.
Schönaicher Strasse 220
D-7030 Böblingen(DE)

(54) **Mask for thermal oxidation and method of forming dielectric isolation surrounding regions.**

(57) The invention relates to a mask for thermal oxidation and a method for forming dielectric isolation surrounding regions.

A mask and a method for eliminating "bird's head and beak" in recessed oxide isolation are described. The ROI mask uses a silicon oxynitride layer confronting the substrate with a silicon nitride layer convering the silicon oxynitride layer.

FIG.4

$Si_3N_4$

$SiO_xN_y$ PAD

Si SUBSTRATE

EP 0 071 203 A2

# MASK FOR THERMAL OXIDATION AND METHOD OF FORMING DIELECTRIC ISOLATION SURROUNDING REGIONS

This invention relates to a mask for thermal oxidation in recessed oxide isolation of a substrate and to a method of forming dielectric isolation surrounding regions of a crystalline silicon.

The invention is used in the manufacture of semi-conductor devices and in particular in processes using recessed oxidation isolation (ROI). The invention eliminates "Bird's Beak" produced by ROI and reduces "Bird's Head" to acceptable levels.

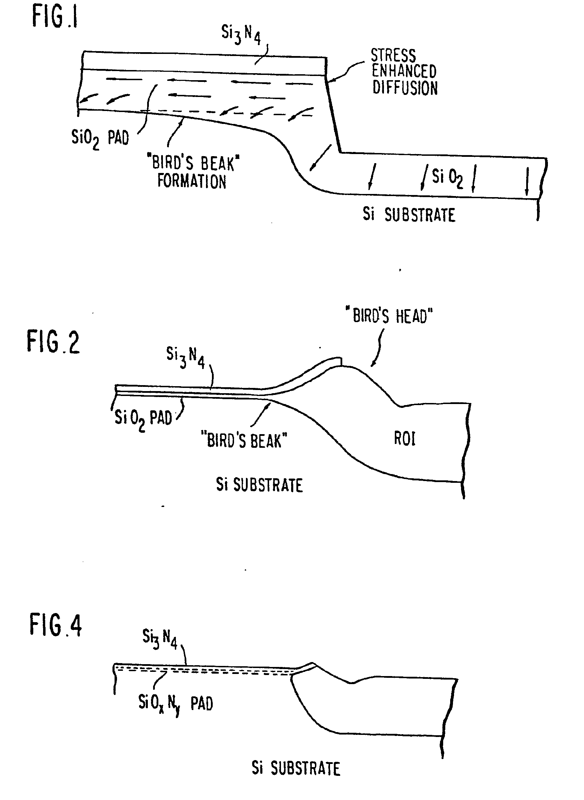

The ROI process has been incorporated into methods of producing a variety of bipolar and FET device designs. The function of this technique is to produce areas of vertical dielectric isolation between devices and is also used within devices to reduce junction capacitance. ROI typically utilizes a nitride/oxide stack which is opened utilizing photolithographic techniques in those areas which are to be oxidized to provide dielectric isolation. As shown in Figure 1, the nitride in the stack acts as an oxidation barrier in the area to be protected while the $SiO_2$ is used as a PAD oxide in the stack to provide a buffer between the nitride and the silicon wafer. In the absence of such a PAD oxide buffer, the stress produced by the nitride layer would generate a high density of defects in the silicon. This, of course, is unacceptable since it significantly decreases yield rates in manufacture. While reducing the high density of defects in the silicon, the nitride-oxide stack produces two additional problems

FI 980 062

in the ROI process. These are known in the technology as "Bird's Beak" and "Bird's Head".

"Bird's Beak", shown in Figure 2 is a result of a substantial lateral penetration of the oxidizing species through the silicon dioxide PAD. This lateral penetration causes an increase in the PAD oxide thickness and is known as "Bird's Beak". A contributing cause is the stress induced in the PAD oxide by the nitride layer. The stress produces an increased diffusivity of the oxidizing species through the PAD oxide shown by the arrows in Fig. 1. This leads to a thin lateral extension of the ROI. It is known that the length of the resulting "Bird's Beak" is proportional to the thickness of the PAD oxide and indirectly proportional to the nitride thickness. The existence of "Bird's Beak" in the ROI process produces production problems in terms of mask alignment necessary when further processing steps are required. For example, in the case of the formation of base and emitter diffusions, instead of having an isolation structure defined by thermally oxidizing the openings, the structure is spread much wider such that it may possibly have an effect on the size of the transistor to be formed within the isolated area. A similar effect would occur for diodes, resistors, and contacts formed within a recessed isolation structure.

The existence of the additional oxidation also increases the volume expansion around the perimeter of the ROI, resulting in an increase in surface nonplanarity. This topography is defined as "Bird's Head" and is shown in a final configuration in Figure 2.

FI 980 062

Within the prior art, a number of alternatives have been suggested to eliminate or substantially reduce the "Bird's Beak" and "Bird's Head" phenomena. Reference is made to U.S. Patent 3 886 000 which utilizes a protective mask or layer of silicon oxynitride ($SiO_xN_y$). This patent utilizes the silicon oxynitride protective mask as a substitute for two prior art techniques. One was the use of a layer of silicon dioxide ($SiO_2$) which had been demonstrated to result in severe vertical penetration of oxygen during oxidation, thereby producing a very thick layer of thermal silicon dioxide beneath the mask. The deficiency of this prior technique was the use of a substantial thickness of the silicon substrate thereby eliminating a significant portion for the active region to be used in forming, for example, transistor elements.

The second suggested technique for which the silicon oxynitride replaced was the use of a mask layer utilizing pure silicon nitride ($Si_3N_4$). In that prior technique, openings were etched in a layer of silicon nitride and the silicon substrate. Then, thermal oxidation of the opening occurred with the silicon nitride preventing lateral or vertical penetration of the silicon dioxide produced in the openings in the silicon substrate. While vertical dielectric isolation occurred, transistor defects due to relatively high stress is created on the underlying substrate make that prior technique unattractive. Finally, the silicon oxynitride mask was suggested in U.S. Patent 3 886 000 as a substitute for the nitride/oxide stack discussed herein which in addition to the production of "Bird's Beak - Bird's Head" also introduced etching problems since three different materials were employed requiring different etchants.

FI 980 062

Accordingly, the prior art Patent 3 886 000 eliminated the silicon dioxide layer and deposited silicon oxynitride directly onto the silicon substrate. The use of oxynitride alone, however, continues to create transistor defects due to high stress on the silicon substrate making this technique also unattractive. A possible explanation of these high stress levels may reside in the amount of oxynitride which converts to oxide during the ROI oxidation process and the fracture strength of the remaining oxynitride layer.

U.S. Patent 3 966 514 also relates to a method of preventing "Bird's Beak". This patent describes a method of forming dielectric isolation utilizing a silicon nitride sidewall layer. While generally effective, the process is complex, difficult to implement, and does not produce acceptable yield rates.

The elimination of the "Bird's Beak - Bird's Head" phenomena is therefore the subject of continuing research. The elimination or significant reduction of this structural irregularity offers a twofold effect in semi-conductor device design. A solution of "Bird's Beak" will allow for a reduction in the horizontal dimensions of most devices by tightening the ground rule and providing the ability to butt diffusions to the ROI. Accordingly, packing density would increase. A solution to the "Bird's Head" problem would provide improved planarity so that stacked vias can be performed at the ROI periphery during personalization wiring. Given these broad criteria, however, any solution must not decrease the yield attained during processing by the introduction of defects into the silicon wafer.

FI 980 062

It is an object of the present invention to eliminate Bird's Beak in ROI processing and to substantially reduce "Bird's Head" to acceptable levels improving planarity of the device.

Another object of this invention is to provide a method of controlling the growth of silicon dioxide for a dielectric isolation barrier for an integrated circuit component of a semi-conductor device.

The objects of this invention have been attained according to claim 1 by providing a mask where the $SiO_2$ PAD is replaced with $SiO_xN_y$.

The oxynitride used in conjunction with silicon nitride acts as a barrier to rapid oxidation. Bird's Beak is eliminated and "Bird's Head" is reduced to acceptable levels. Given the compatibility of the layers, minimal tensile stresses are generated and therefore defects in adjacent silicon wafer structures do not result.

The method of forming dielectric isolation surrounding regions according to claim 4 allows the control of nonuniformity in recessed oxide isolation.

These and other objects, features and advantages of this invention will become apparent with reference to the description of the preferred embodiment and the accompanying drawings.

Fig. 1     is a schematic sectional view showing prior art ROI processing utilizing a silicon nitride layer over a silicon dioxide PAD;

FI 980 062

Fig. 2    is a schematic sectional view of a semi-conductor showing the resulting formation of "Bird's Beak - Bird's Head" as a result of processing the layers of Fig. 1;

Fig. 3    is a graph showing experimental results eliminating "Bird's Beak" by utilizing the layer composition in accordance with the present invention;

Fig. 4    is a schematic sectional view of an SEM photograph analyzing ROI performed with a $SiO_xN_y$ PAD; and

Fig. 5    is a graph of MOS C-t yield % as a function of refractive index.

Referring to Figures 1 and 2, an examination of the "Bird's Beak" phenomena by the inventor resulted in the identification of several possible mechanisms to explain this occurrence. The enhanced diffusion of the oxidant during the process occurred either at the nitride oxide interface or through the bulk of the PAD oxide. An experiment utilizing various thicknesses (5nm to 100nm) of polycrystalline silicon between the oxide and the nitride layers was performed to determine the true mechanism. The results of ROI formation with these masking layers indicated no reduction in the amount of "Bird's Beak" obtained.

The mechanism was, therefore, concluded to be one of rapid diffusion through the bulk of the PAD oxide. An understanding of the exact mechanism therefore suggested a solution to the problem. In accordance with the present invention, a replacement of the PAD oxide with

FI 980 062

a material which would act both as a buffer to the stress induced by the nitride barrier yet also retard or eliminate the rapid diffusion of the oxidant would eliminate "Bird's Beak". It is upon that recognition that the present invention proceeds. The most attractive material is $SiO_xN_y$ because of its compatibility with present processing techniques. As defined herein, results utilizing this substitution have been obtained and are presented in terms of the experimental data which follows.

The deposition of $SiO_xN_y$ was performed in an AMT Nitrox Reactor at 800°C utilizing various mixtures of $SiH_4$, $N_2O$, and $NH_3$. All layers were analyzed by ellipsometer for refractive index and thickness determinations. The ROI structures were analyzed utilizing SEM and TEM techniques while yields were obtained utilizing MOS retention time on blanket wafers.

- 8 -

## TABLE 1

### T.E.M. Analysis

| Wafer No. | Refractive Index | Comments |
|-----------|------------------|--------------|
| 7 | 1.64 | No Defects |
| 8 | 1.73 | No Defects |
| 9 | 1.83 | No Defects |
| 2 | 1.85 | |
| 6 | 1.88 | No Defects |
| 10 | 1.92 | Some Defects |
| 15 | 1.93 | Some Defects |
| 22 | 2.02 | |

## TABLE 2

### MOS (C-t) Yield

$(SiO_xN_y$ R.I.=1.83)

| Wafer No. | Under ROI | Under N/ON Stack | C-t Control |
|-----------|-----------|------------------|-------------|
| 1 | 90% | — | — |
| 2 | — | — | 98% |
| 3 | 100% | 96% | |
| 4 | 82% | 100% | |
| 5 | 100% | 96% | |

Under ROI average = 94%

Under N/ON average = 97%

A first experiment was designed to determine at what composition of oxynitride the "Bird's Beak" problem was eliminated. Utilizing conditions which are customary for the deposition of $SiO_2$ and $Si_3N_4$ at 800°C, the $N_2O$ input was decreased at 10% intervals from normal as the $NH_3$ was increased at corresponding 10% intervals. This procedure produced a complete range of refractive indexes from 1.49 to 2.03.

In each case, the thickness of the oxynitride layers was 100 nm. This was followed by the deposition of 50 nm of $Si_3N_4$ and 100 nm of $SiO_2$ for masking. The mask used was a grid pattern of 7.5 μm lines on 15 μm centers and the lines are opened by reactive ion etching (RIE) in $CF_4/H_2$. The exposed silicon was etched in a $CrO_3$-HF etch for 380 nm, followed by 1.0 μm thermal oxidation at 1000°C (D-W-D).

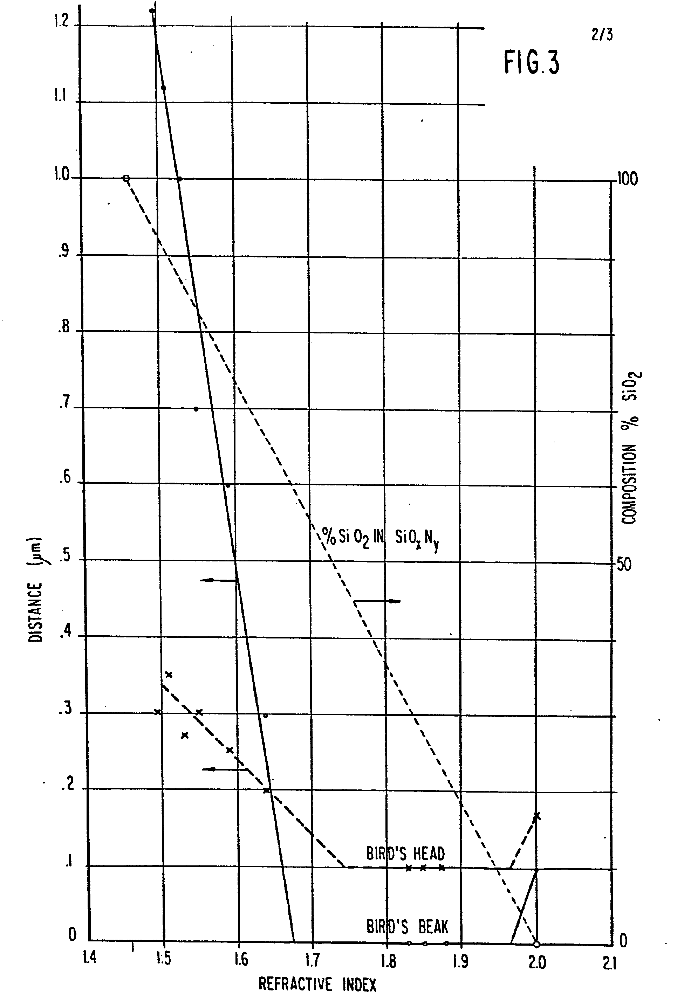

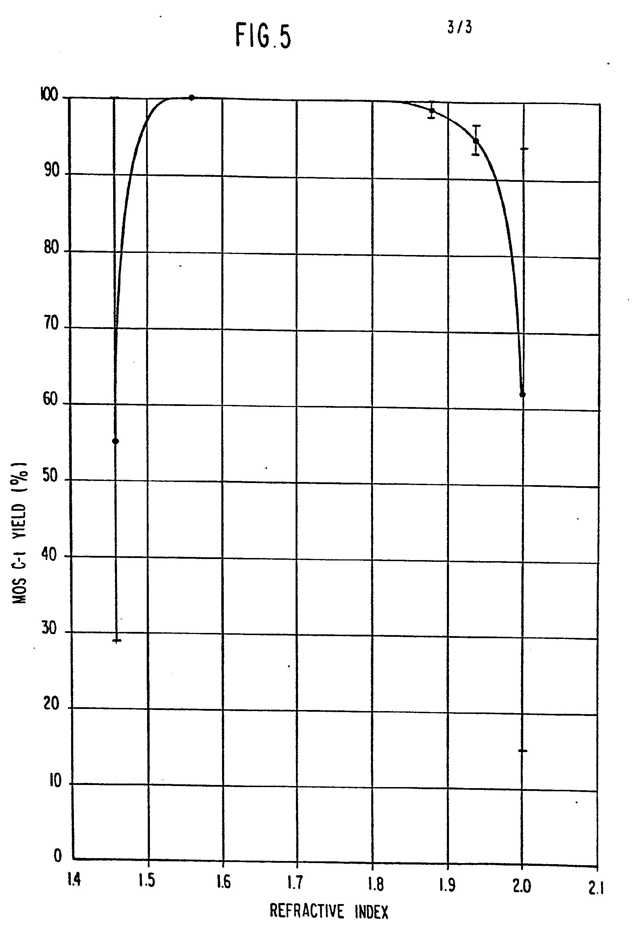

Referring to Figure 3, the results of the SEM analysis on cleaved sections is shown. As indicated in that Figure, as the nitride content of the oxynitride layer increases, both the "Bird's Beak" and "Bird's Head" decrease in magnitude. The decrease is shown and identified. It is observed that the "Bird's Beak" is entirely eliminated for refractive indexes greater than 1.65 while the "Bird's Head" reaches a minimum of 100 nm at 1.74. Figure 4, showing an SEM analysis, portrays these minimum conditions.

If from Figure 3 it is assumed that a linear relationship for refractive index exists versus composition, the oxynitride at 1.75 contains 46% $SiO_2$/54% $Si_3N_4$.

A selection of such process wafers were evaluated by TEM for evaluation of defect generation. These results

FI 980 062

are produced in Table 1 herein. As shown, it is apparent that the oxynitride acts as an effective buffer to nitride stress up to a refractive index of 1.9. In wafers subjected to TEM, no defects were observed below this value. It is noted from Table 1 that above 1.9 defects were noted in the specimens analyzed.

To further define the effective utilization in terms of the effect of oxynitride on overall defect density two additional experiments utilizing MOS retention time (C-t) were performed. In the first, three substrates (P-15Ωcm) were prepared with a nitride/oxy-nitride (N/ON) stack. Half of the substrates were masked and etched in hot phosphoric acid. The refractive index of the PAD was 1.83 and etched in phosphoric acid at approximately the same rate as the $Si_3N_4$. The exposed silicon was etched for 400 nm in a $CrO_3$-HF solution followed by thermal oxidation of 650 nm at 1000°C. All dielectric films were removed in hot phosphoric and BHF and a new 50 nm gate oxide grown. A high density aluminum dot pattern was deposited and annealed in forming gas.

MOS (C-t) measurements were obtained on the 0.51 mm dots and the results are set forth in Table 2 above. The C-t yields were found to average 97% and 94% for areas under the N/ON stack and under the ROI, respectively. This compares favorably with control wafers for the ROI and the gate oxidations of 90% and 98%.

A second C-t experiment tested the yields of P(2Ωcm) wafers for various oxynitride compositions. In this experiment, no mask was employed so that all results are for under the N/ON stack. The ROI oxidation cycle in this case was 1.0 μm oxidation at 1000°C. The yields

FI 980 062

were found to degenerate for refractive indexes greater than 1.90 as shown in the chart, Fig. 5. This indicates definite defect generation due to stress. These results, along with those of SEM and TEM analysis, define the effective composition range for the oxynitride PAD to have a refractive index of 1.65 to 1.90. This experiment also shows sporadic defect generation for wafers utilizing an oxide PAD.

Continuing experimentation in the range of 1.65 to 1.83 demonstrated that the higher refractive indexes produce a sporadic run to run dependency toward defects such that the preferred operating range is from 1.65 to 1.75 in which low defect densities are attainable. It is reasonable that the lowest refractive index be utilized which prevents "Bird's Beak" and reduces "Bird's Head".

Accordingly, then, as described herein, successful fabrication of a recessed oxide isolation (ROI) without undesirable "Bird's Beak" and with a correspondingly acceptable reduction of "Bird's Head" has been accomplished by the replacement of the PAD oxide with silicon oxynitride. The oxynitride has a refractive index of 1.76 ± 0.13 such that it etches in hot phosphoric acid at approximately the same rate as silicon nitride. It has also been demonstrated that oxynitride is an effective buffer between silicon nitride and silicon and that no defects are generated in the silicon due to stress.

It is apparent that other applications of this invention are within the scope of this invention. For example, the invention is applicable to certain areas of FET and bipolar devices.

FI 980 062

- 12 -

## C L A I M S

1. Mask for thermal oxidation in recessed oxide isolation of a substrate comprising;

   a stack having a silicon oxynitride layer confronting said substrate and a silicon nitride layer covering the silicon oxynitride layer.

2. Mask of claim 1 wherein said silicon oxynitride has a refractive index in the range of 1.65 to 1.90.

3. Mask of claim 1 wherein said silicon oxynitride has a refractive index of 1.70.

4. Method of forming dielectric isolation surrounding regions of crystalline silicon comprising the steps of:

   depositing a layer of silicon oxynitride on surface of said silicon,

   depositing a layer of silicon nitride on said layer of silicon oxynitride;

   forming openings in said layers of silicon nitride and silicon oxynitride to said surface at locations where dielectric isolation regions are to be formed;

   etching a trench in said silicon using said layers as a mask, and

FI 980 062

- 13 -

oxidizing said silicon in said openings to form a dielectric isolation region of silicon dioxide, wherein the silicon oxynitride layer acts as a barrier to surface oxidation of said silicon under said silicon oxynitride during oxidizing.

5. Method of claim 4 wherein said silicon oxynitride has a refractive index in the range of 1.65 to 1.90.

6. Method of claim 5 wherein said silicon oxynitride has a refractive index of 1.70.

FIG.1

$Si_3N_4$

STRESS
ENHANCED
DIFFUSION

$SiO_2$ PAD

"BIRD'S BEAK"
FORMATION

$SiO_2$

Si SUBSTRATE

FIG.2

"BIRD'S HEAD"

$Si_3N_4$

$SiO_2$ PAD

"BIRD'S BEAK"

ROI

Si SUBSTRATE

FIG.4

$Si_3N_4$

$SiO_xN_y$ PAD

Si SUBSTRATE

FIG.3

0071203

2/3

FIG.5